# EUROPÄISCHE PATENTSCHRIFT

(11) **EP 3 159 740 B1**
(45) Veröffentlichungstag und Bekanntmachung des Hinweises auf die Patenterteilung: **01.08.2018**
(21) Anmeldenummer: 15191051.0
(22) Anmeldetag: 22.10.2015
(51) Int. Cl.: B41C 1/00, B41C 1/14, G03F 7/00, G03F 7/027, G03F 7/20

(54) **VERFAHREN ZU GENERATIVEN HERSTELLUNG VON RELIEFDRUCKFORMEN**
METHOD FOR GENERATIVE PRODUCTION OF RELIEF PRINTING PLATES
PROCEDE DE FABRICATION GENERATIVE DE FORMES D'IMPRESSION EN RELIEF

(43) Veröffentlichungstag der Anmeldung: 26.04.2017
(73) Patentinhaber: Flint Group Germany GmbH, 70469 Stuttgart (DE)
(72) Erfinder: TELSER, Thomas, 69123 Heidelberg-Wieblingen (DE); FREUDENTHALER, Eva, 70825 Korntal-Münchingen (DE)
(74) Vertreter: Schuck, Alexander

(56) Entgegenhaltungen:
- EP-A1- 1 428 666
- EP-A1- 2 199 082

## Beschreibung

### Stand der Technik

Die Erfindung betrifft ein Verfahren zur Herstellung von Reliefdruckformen, wobei ein Träger mit einer polymeren Substratschicht bereitgestellt wird und ein Relief an einer Oberfläche der Substratschicht schichtweise ausgebildet wird.

Reliefdruckformen wie beispielsweise Flexodruckformen werden beispielsweise zum Bedrucken verschiedenster Verpackungen mit niedrig viskosen Druckfarben verwendet. Als Druckfarben werden meist polare Druckfarben auf Wasser- oder Alkoholbasis verwendet. Aufgrund des Druckverfahrens werden Flexodruckformen benötigt, die weich, elastisch und beständig gegenüber polaren Flexodruckfarben sind.

Übliche Flexodruckplatten enthalten daher ein weichelastisches, unpolares Bindemittel, meist Blockcopolymere auf Basis Styrol-Isopren oder Styrol-Butadien, in Kombination mit Monomeren, Weichmachern und einem oder mehreren Fotoinitiatoren (siehe beispielsweise US 4,323,636). Diese fotopolymerisierbare Schicht ist im Allgemeinen wenige Millimeter dick und befindet sich auf einem dimensionsstabilen Träger, meist einer PET-Folie. Das Relief wird durch Belichten mit UV-Licht durch ein Filmnegativ erzeugt. Bei der Belichtung vernetzen die belichteten Bereiche, die unbelichteten Bereiche der Flexodruckplatte bleiben dagegen löslich und werden durch Auswaschen in einem geeigneten organischen Lösungsmittel entfernt.

Alternativ zur Filmbelichtung können Flexodruckplatten auch durch eine mittels Laser erzeugte Maske belichtet werden. Die dünne ablatierbare Maskenschicht befindet sich auf der photopolymerisierbaren Schicht (siehe beispielsweise US 5,262,275). Durch bildmäßige Ablation wird eine Maske erzeugt, durch die anschließend mit UV-Licht belichtet wird.

Unabhängig davon, ob die UV-Belichtung der photopolymerisierbaren Schicht durch einen Film oder durch eine mittels Laser erzeugte integrale Maske erfolgt, muss das Relief anschließend durch Auswaschen in geeigneten organischen Lösungsmitteln erzeugt werden (siehe beispielsweise EP 332 070).

Beim Auswaschen des Reliefs quellen auch die vernetzten Bereiche der Flexodruckplatte an. Dieses Lösungsmittel muss in einem Trocknungsschritt wieder entfernt werden. Durch die Temperaturempfindlichkeit der PET-Trägerfolie kann die Trocknung der Flexodruckformen bei maximal 60°C durchgeführt werden. Die notwendigen Trocknungszeiten sind lang. Je nach Schichtdicke der Flexodruckplatte werden Trocknungszeiten von 30 Minuten bis zu mehreren Stunden benötigt.

Es hat daher nicht an Versuchen gefehlt, Flexodruckformen zu entwickeln, die schneller entwickelt werden können. Beispielsweise können Flexodruckplatten auch thermisch entwickelt werden (siehe beispielsweise EP 1 239 329 oder EP 1 170 121). Hierbei werden die Flexodruckplatten nach der bildmäßigen Belichtung bis zur Schmelzetemperatur erwärmt. Die unbelichteten Bereiche der Flexodruckplatte werden dadurch klebrig und werden dann durch Auflegen eines Vlies oder eines Gewebes abgezogen. Allerdings ist das Verfahren apparativ aufwändig, da mehrere Lagen nacheinander abgezogen werden müssen, um ein ausreichendes Relief zu erzeugen. Ferner ist die Auflösung der so hergestellten Flexodruckformen geringer als die Auflösung von in Lösungsmitteln ausgewaschenen Flexodruckformen.

Grundsätzlich wäre daher ein Verfahren wünschenswert, indem das Relief nicht durch einen Entwicklungsschritt erzeugt, sondern generativ (d.h. reliefaufbauend) hergestellt wird. Hierdurch könnte die Herstellzeit einer Reliefdruckform erheblich verkürzt und vereinfacht werden. Ferner würde erheblich weniger Material benötigt und die Ökobilanz einer derart hergestellten Druckform wäre wesentlich verbessert.

Bekannt sind verschiedene Methoden ein Druckrelief mittels Ink-jet schichtweise aufzubauen (siehe beispielsweise EP0641648, US2004/0131778, EP2033778, WO2012/175525, WO2014/095361, US2008/0053326, EP2199082, EP1428666). Das allgemeine Prinzip dieser Patentschriften ist es, eine reaktive Monomermischung, beispielsweise eine Monomer/Fotoinitiatormischung, mittels eines Tintenstrahldruckverfahrens bildmäßig auf ein geeignetes Substrat aufzutragen und möglichst umgehend mittels UV-Licht zu immobilisieren bzw. zu härten, so dass die aufgetragenen Tröpfchen nicht spreiten oder verfließen können. Das Relief wird aufgebaut, indem so mehrere Schichten nacheinander aufgetragen werden.

Eine Flexodruckform mittels eines Tintenstrahldruckverfahrens aufzubauen, hat jedoch entscheidende Nachteile. Über einen Tintenstrahldruckkopf können nur Flüssigkeiten mit niedriger Viskosität aufgebracht werden. Üblicherweise liegt die Grenzviskosität bei Viskositäten <15 mPas. Es können daher nur relativ kleine Moleküle zur Formulierung der reaktiven Monomermischung verwendet werden. Diese Monomere sind nicht in der Lage, ein weichelastisches, beständiges Material zu bilden, wie es für Flexodruckformen benötigt wird. Da die reaktiven Monomere meist aus der Klasse der Acrylsäure- oder Methacrylsäureester ausgewählt sind, sind die aufgebauten Materialien entweder zu hart oder sie sind ausreichend weich, aber dann gegenüber den polaren Flexodruckfarben nicht beständig.

US2008/0053326 beschreibt ein Verfahren, mit dem elastische Prepolymere oder Polymere über ein Tintenstrahldruckverfahren aufgetragen und vernetzt werden und ein flexotypisches Reliefmaterial schichtweise aufgebaut wird. Die Materialien müssen erwärmt werden, so dass dünnflüssige Schmelzen entstehen, die über das Tintenstrahlverfahren aufgebracht werden können.

EP 1552922 umgeht das Viskositätsproblem dadurch, dass feste Partikel in einer Trägerflüssigkeit dispergiert werden und diese Dispersion dann in einem Tintenstrahldruckverfahren schichtweise aufgebracht wird. Die Trägerflüssigkeit muss bei diesem Verfahren aber wieder entfernt werden, was das Verfahren aufwändig macht.

US6641772 beschreibt ein Stereolithographieverfahren, mit dem flexotypische Materialien aufgebaut werden können. Hierbei wird eine temperaturempfindliche Harzlösung oder Schmelze mit einem IR-Laser punktuell aufgeheizt und zu dreidimensionalen Gebilden thermisch gehärtet. Das Verfahren ist apparativ aufwändig.

Es besteht daher ein Bedarf an einem generativen (d.h. reliefaufbauenden) Verfahren, mit dem eine Flexodruckform einfach und sicher hergestellt werden kann. Insbesondere besteht ein Bedarf nach generativen Flexodruckformen, die die notwendige Weichelastizität und die notwendige Quellbeständigkeit gegenüber ethanolbasierten oder wasserbasierten Druckfarben aufweisen.

Überraschenderweise wurde gefunden, dass ein Relief mit guter Beständigkeit gegen die Druckfarben und der geforderten Weichelastizität erhalten wird, wenn die aufgetragene reaktive Flüssigkeit nicht möglichst umgehend immobilisiert bzw. mittels UV-Strahlung ausgehärtet wird, sondern der reaktiven Flüssigkeit ausreichend Zeit zum Eindiffundieren in ein geeignetes polymeres Trägermaterial gegeben wird, bevor die nächste Flüssigkeitslage aufgetragen wird, und erst nach Aufbringen einiger Lagen oder aller Lagen eine Aushärtung durchgeführt wird.

Dementsprechend wird ein Verfahren zur Herstellung von Reliefdruckformen vorgeschlagen, bei dem ein Träger mit einer polymeren Substratschicht bereitgestellt wird und ein Relief an einer Oberfläche der Substratschicht schichtweise ausgebildet wird. Das Relief wird ausgebildet mittels
a) einfachen oder mehrfachen Aufbringens einer Flüssigkeit enthaltend mindestens ein reaktives Monomer auf die Oberfläche der polymeren Substratschicht,
b) Eindiffundieren des reaktiven Monomers in die polymere Substratschicht für eine vorgegebene Einwirkzeit und
c) Aushärten des Reliefs,
wobei in Schritt a) die Flüssigkeit bildmäßig auf die Oberfläche aufgetragen wird und wobei nach der vorgegebenen Einwirkzeit gegebenenfalls noch auf der Oberfläche verbliebene nicht eindiffundierte Flüssigkeit von der Oberfläche entfernt wird und in Schritt c) ein Aushärten des Reliefs umfassend das Polymer der Substratschicht und eindiffundiertes reaktives Monomer erfolgt.

Die zum Ausbilden des Reliefs aufgetragene Flüssigkeit umfasst mindestens ein reaktives Monomer, welches bei dem vorgeschlagenen Verfahren in die Substratschicht eindiffundiert. Erst nachdem das reaktive Monomer durch die Substratschicht aufgenommen wurde, erfolgt eine Aushärtung, durch die das reaktive Monomer immobilisiert wird. Nach der Aushärtung erfolgt keine weitere Diffusion des reaktiven Monomers in der Substratschicht. Durch das Eindringen des reaktiven Monomers in die polymere Substratschicht wird das Relief nicht auf der polymeren Substratschicht aufgebaut, sondern die polymere Substratschicht selbst wird aufgrund des eindiffundierten Materials angehoben und bildet das Relief aus. Im Gegensatz zu den Verfahren nach dem Stand der Technik ist das Material des Reliefs nicht alleine durch die aufgebrachte Flüssigkeit bzw. das reaktive Monomer vorgegeben, sondern das Relief bzw. eine einzelne Reliefschicht wird durch eine Mischung aus dem Material der polymeren Substratschicht und dem reaktiven Monomer aufgebaut. Das Material des Reliefs ergibt sich somit aus der Kombination des in der Flüssigkeit enthaltenen reaktiven Monomers und dem Material der polymeren Substratschicht.

Das Relief wird schichtweise aufgebaut, wobei die Anzahl der für das Relief verwendeten Reliefschichten abhängig ist von der Höhe einer einzelnen Reliefschicht und der gewünschten Gesamthöhe bzw. Tiefe des Reliefs. Hierbei ist die Tiefe des Reliefs abhängig vom Einsatzzweck der Druckform. Im Flexodruck werden Reliefdruckformen mit einer Relieftiefe im Bereich von 300 µm bis 3000 µm verwendet. Beim Druck flexibler Verpackungen beträgt die Relieftiefe 300 µm bis 700 µm. In anderen Anwendungen, beispielsweise im Elektronikbereich, bei dem leitfähige Strukturen auf einer Leiterplatte oder einem anderen Substrat erzeugt werden, werden Reliefdruckformen mit einer Relieftiefe im Bereich von 10 µm bis 100 µm benötigt.

Die Schritte des Aufbringens der Flüssigkeit auf die Oberfläche und das Eindiffundieren des reaktiven Monomers in die Substratschicht werden so oft wiederholt, bis das vollständige Relief mit gegebenenfalls mehreren Reliefschichten aufgebaut wurde. Jede einzelne Reliefschicht stellt dabei einen horizontalen Schnitt durch das Gesamtrelief dar. Dementsprechend wird zum Ausbilden einer Reliefschicht die Flüssigkeit derart bildmäßig auf die Oberfläche aufgebracht, dass ein durch das zu erzeugende Relief vorgegebenes Auftragsmuster entsteht. Das Auftragsmuster kann beispielsweise erhalten werden, indem horizontale Schnitte durch die Geometrie des zu erzeugenden Reliefs ermittelt werden, wobei das Auftragsmuster für eine zu erzeugende Reliefschicht durch die Form des horizontalen Schnitts durch die Geometrie des Reliefs bei der entsprechenden Höhe bzw. Relieftiefe gegeben ist. Je nach Ausführungsvariante des Verfahrens können hierbei die Dicken aller Reliefschichten gleich oder unterschiedlich gewählt werden. Beispielsweise ist es möglich, die Dicke einer Reliefschicht mit zunehmender Relieftiefe zu verringern. Ebenso ist es denkbar, die Eigenschaften der Reliefschichten mit zunehmender Relieftiefe durch Verwenden einer anderen Flüssigkeit, die beispielsweise ein anderes reaktives Monomer enthält, zu variieren.

An das Aufbringen der Flüssigkeit schließt sich das Eindiffundieren des reaktiven Monomers in die polymere Substratschicht für eine vorgegebene Einwirkzeit an. Typischerweise liegt die Einwirkzeit im Bereich von 10 Sekunden bis zu 3600 Sekunden. Die Einwirkzeit ist hierbei abhängig von der Diffusionsgeschwindigkeit des reaktiven Monomers in die polymere Substratschicht, also abhängig davon, wie schnell das reaktive Monomer von der polymeren Substratschicht aufgenommen wird. Die Diffusionsgeschwindigkeit wiederum hängt von dem verwendeten reaktiven Monomer und dem verwendeten Material der polymeren Substratschicht ab. Da das Material des Reliefs nicht alleine aus dem reaktiven Monomer bestehen soll, ist bevorzugt vorgesehen, dass die Einwirkzeit derart vorgegeben ist, dass das aufgebrachte reaktive Monomer nach Verstreichen der Einwirkzeit von der Substratschicht aufgenommen wurde. Hierbei wird das reaktive Monomer als von der Substratschicht aufgenommen angesehen, wenn nach Verstreichen der Einwirkzeit weniger als 10 % der aufgebrachten Menge an reaktivem Monomer noch auf der Oberfläche der polymeren Substratschicht vorhanden ist. Besonders bevorzugt ist die aufgebrachte Flüssigkeit bzw. das reaktive Monomer nach Verstreichen der Einwirkzeit vollständig aufgenommen, so dass an der Oberfläche der Substratschicht kein reaktives Monomer verbleibt.

Sollte nach Verstreichen der Einwirkzeit auf der Oberfläche der Substratschicht noch reaktives Monomer vorhanden sein, so ist vorgesehen, dass das auf der Oberfläche verbliebene reaktive Monomer entfernt wird. Somit wird das Material des Reliefs aus dem Material der Substratschicht und aus dem in die Substratschicht eindiffundierten reaktiven Monomer gebildet. Die Dicke einer Reliefschicht ist demnach abhängig von der Diffusionsgeschwindigkeit des reaktiven Monomers in dem Material der Substratschicht, der Einwirkzeit und gegebenenfalls von der Menge der aufgebrachten Flüssigkeit bzw. der Menge des aufgebrachten reaktiven Monomers.

Die Diffusionsgeschwindigkeit des reaktiven Monomers in der Substratschicht beeinflusst des Weiteren das Profil der Flanken des Reliefs bzw. einer Reliefschicht. Dies ist dadurch begründet, dass die Diffusion nicht nur in eine Richtung senkrecht zur Oberfläche der Substratschicht erfolgt, sondern auch in Richtungen, die in der Ebene der Substratschicht liegen. Bei niedriger Diffusionsgeschwindigkeit und für kurze Einwirkzeiten ergeben sich steile Flanken. Mit zunehmender Einwirkzeit und für zunehmende Diffusionsgeschwindigkeiten nimmt die Steilheit der Flanken ab. Es ist daher bevorzugt, für die obersten Reliefschichten, die zuletzt aufgebracht werden, eine reaktives Monomer mit geringerer Diffusionsgeschwindigkeit zu wählen als für die unteren Reliefschichten, die zuerst aufgebracht werden. Alternativ oder zusätzlich ist es bevorzugt, die Einwirkzeit für die obersten Reliefschichten, die zuletzt aufgebracht werden, kürzer zu wählen als für die unteren Reliefschichten, die zuerst aufgebracht werden. Auf diese Weise wird die Schärfe des Abbilds im Relief erhöht, wobei gleichzeitig die für den Aufbau des Gesamtreliefs benötigte Zeit minimiert wird.

Bevorzugt kann vorgesehen sein, dass zunächst ein reaktives Monomer mit hoher Diffusionsgeschwindigkeit in der polymeren Substratschicht eingesetzt wird, und später ein anderes reaktives Monomer mit einer geringeren Diffusionsgeschwindigkeit in der polymeren Substratschicht verwendet wird. Auf diese Weise lassen sich bei im Wesentlichen gleicher Einwirkzeit für jede der Reliefschichten zunächst Reliefschichten mit größerer Dicke erzeugen, so dass das Gesamtrelief möglichst rasch aufgebaut wird. Bei den weiter außen liegenden Schichten wird dann auf ein reaktives Monomer mit geringerer Diffusionsgeschwindigkeit gewechselt, um das gewünschte Bild im Relief präziser abbilden zu können.

Nach dem Aufbringen der Flüssigkeit enthaltend mindestens ein reaktives Monomer und nach Ablauf der vorgegebenen Einwirkzeit ist gemäß Schritt c) vorgesehen, dass ein Aushärten des Reliefs erfolgt. Bei dem Aushärten des Reliefs bildet das reaktive Monomer mit dem Polymer der Substratschicht ein dreidimensionales Netzwerk aus und eine weitere Diffusion des reaktiven Monomers in der Substratschicht wird gestoppt. Typischerweise ist die für die Aushärtung erforderliche Einwirkung von dem verwendeten reaktiven Monomer und den gegebenenfalls eingesetzten Fotoinitiatoren abhängig. Das Aushärten kann beispielsweise durch Einwirkung von Wärme oder Strahlung erfolgen. Bevorzugt werden reaktive Monomere in Kombination mit Fotoinitiatoren eingesetzt, die sich durch Einwirkung von elektromagnetischer Strahlung, insbesondere von ultraviolettem Licht aushärten lassen. Bevorzugt werden die Fotoinitiatoren hierbei nicht der Flüssigkeit zugegeben sondern sind in der Substratschicht enthalten. Ultraviolettes Licht (UV-Licht) weist eine Wellenlänge im Bereich von 100 nm bis 400 nm auf. Besonders bevorzugt werden hierbei reaktive Monomere, die sich durch Einwirkung von UV-A Strahlung aushärten lassen. UV-A Strahlung weist eine Wellenlänge im Bereich von 320 nm bis 400 nm auf. Zum Entkleben der Oberfläche der Reliefdruckplatte kann im Anschluss eine weitere Aushärtung mit UV-C Strahlung erfolgen. UV-C Strahlung weist eine Wellenlänge im Bereich von 100 bis 280 nm auf.

Zum Aushärten kann beispielsweise eine UV-Lichtquelle, insbesondere eine Lichtquelle mit Strahlung im UV-A Bereich, vorgesehen sein. Beispielsweise kann die UV-Lichtquelle als LED (light emitting diode)-Leiste ausgestaltet sein, die relativ zum Träger bewegt wird, um dessen gesamte Oberfläche zu überstreichen.

Bevorzugt ist vorgesehen, dass die Schritte a) bis c) einmalig durchlaufen werden. Hierbei erfolgt bevorzugt im Schritt a) ein einfaches Aufbringen der Flüssigkeit auf die Oberfläche der Substratschicht. An das Aufbringen der Flüssigkeit gemäß Schritt a) schließen sich in dieser Reihenfolge die Schritte b) und c) an, so dass das mit der Flüssigkeit aufgebrachte reaktive Monomer in die Substratschicht eindiffundiert und anschließend das Relief, welches das reaktive Monomer und das Material der polymeren Substratschicht umfasst, ausgehärtet wird.

Alternativ hierzu ist bevorzugt vorgesehen, dass die Schritte a) und b) 2 bis 100 mal durchlaufen werden, wobei sich jeweils ein Schritt des Eindiffundierens an einen Schritt des Auftragens der Flüssigkeit anschließt und nach dem letzten Durchlaufen des Schritts b) ein Aushärten gemäß Schritt c) erfolgt.

Hierbei kann vorgesehen sein, dass das Aushärten gemäß Schritt c) zusätzlich nach jedem n-ten Durchlaufen der Schritte a) und b) ausgeführt wird, wobei n eine natürliche Zahl ist und von 2 bis 10 gewählt ist. Die zusätzliche Ausführung des Aushärtens gemäß Schritt c) stellt hierbei eine Zwischenaushärtung dar, durch die in die polymere Substratschicht eindiffundiertes reaktives Monomer ausgehärtet und damit immobilisiert wird, so dass eine weitere Diffusion des bereits eindiffundierten reaktiven Monomers in dem Material der polymeren Substratschicht unterbunden wird. Die Aushärtung erfolgt hierbei bevorzugt auf gleiche Weise wie die nach dem Aufbringen aller Reliefschichten vorgesehene Aushärtung.

Das Aufbringen der Flüssigkeit gemäß Schritt a) kann mit jedem Verfahren erfolgen, welches ein bildmäßiges bzw. strukturiertes Auftragen einer Flüssigkeit auf eine Oberfläche ermöglicht. Hierbei entspricht die Struktur des Auftrags dem auf dem Relief zu erzeugenden Abbild.

Zum Aufbringen einer Schicht der reaktiven Flüssigkeit kann beispielsweise eine Maske auf die Oberfläche der polymeren Substratschicht aufgebracht werden, bei der diejenigen Bereiche der Oberfläche der Substratschicht, auf denen keine Flüssigkeit aufgetragen werden soll, mit der Maske abgedeckt werden. Nach dem Aufbringen der Maske erfolgt ein flächiges Auftragen der Flüssigkeit, wobei die Flüssigkeit durch die Maske auf die Oberfläche der polymeren Substratschicht gelangt, und im Anschluss ein Entfernen der Maske. Dabei kann das Entfernen der Maske direkt nach dem Auftragen der Flüssigkeit oder erst nach Ablauf der vorgegebenen Einwirkzeit erfolgen. Das flächige Auftragen kann beispielsweise erfolgen, indem der Träger mitsamt der auf der polymeren Substratschicht aufgebrachten Maske durch ein Flüssigkeitsbad gezogen oder in ein Flüssigkeitsbad getaucht wird. Alternativ kann die reaktive Flüssigkeit flächig durch Rakeln, Aufsprühen oder mittels eines geeigneten Walzenauftragsverfahren auf die mit der Maske bedeckte Substratschicht aufgetragen werden.

Die bei dem Verfahren eingesetzte Flüssigkeit umfasst mindestens ein reaktives Monomer. Die Flüssigkeit kann insbesondere auch eine Mischung aus zwei oder mehr verschiedenen Monomeren umfassen. Optional umfasst die Flüssigkeit zusätzlich einen Fotoinitiator. Die Flüssigkeit wird aufgrund des enthaltenen reaktiven Monomers auch als reaktive Flüssigkeit bezeichnet.

Bevorzugt ist das mindestens eine reaktive Monomer im Verhältnis zum verwendeten Träger derart ausgewählt, dass die Diffusionsgeschwindigkeit des reaktiven Monomers in dem Material der polymeren Substratschicht im Bereich von 0,5 µm/min bis 100 µm/min bevorzugt in einem Bereich von 2 µm/min bis 50 µm/min liegt.

Die Diffusionsgeschwindigkeit ist üblicherweise temperaturabhängig. Bevorzugt wird die gewünschte Diffusionsgeschwindigkeit des reaktiven Monomers in dem Material der polymeren Substratschicht bei der Temperatur erreicht, bei der der Auftrag der Flüssigkeit auf die Oberfläche der Substratschicht erfolgt. Beispielsweise erfolgt der Auftrag der Flüssigkeit bei einer Temperatur im Bereich von 20 bis 120°C. Die natürliche Obergrenze der Auftragstemperatur ist durch den Siedepunkt des reaktiven Monomeren gegeben. Üblicherweise liegt die maximale Auftragstemperatur unter dem Siedepunkt des reaktiven Monomeren.

Reaktive Monomere können beispielsweise ethylenisch ungesättigte Verbindungen sein, die radikalisch gehärtet werden können. Alternativ können die reaktiven Monomere auch Epoxid- oder Aziridinfunktionen enthalten, die nach einem kationischen Mechanismus härten können.

Bevorzugte Monomere weisen mindestens eine polymerisierbare, ethylenisch ungesättigte Doppelbindung auf. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure oder Allylverbindungen erwiesen. Ganz besonders bevorzugte Monomere sind Mono-, Di- und Triacrylate sowie -methacrylate.

Beispiele für geeignete Monomere sind Methylmethacrylat, Ethylacrylat, Propyl(meth)acrylat, Butyl(meth)acrylat, 2-Ethylhexylacrylat, Laurylacrylat, Butandioldi(meth)acrylat, Hexandioldi(meth)acrylat, Nonandioldi(meth)acrylat, Dodecandioldi(meth)acrylat, Trimethylolpropantri(meth)acrylat, Hydroxyethyl-(meth)acrylat, Ethylenglykol(meth)acrylat, Ethylenglykoldi(meth)acrylat, Tri- bzw. Tetraethylenglykol(meth)acrylate, Glycerindi(meth)acrylat, Propylenglykolmono-bzw. -di(meth)acrylate, Trimethylolpropantri(meth)acrylat, Pentaerythritol-tetra(meth)acrylat sowie Poly(ethylenoxid)acrylate bzw. -methacrylate oder Poly(propylenoxid)acrylate bzw. -methacrylate.

Weitere geeignete reaktive Monomere können sein Glycidyl(meth)acrylat, Phenylglycidether(meth)acrylat, Benzyl(meth)acrylat, Cyclohexyl(meth)acrylat, Isobornyl(meth)acrylat, Dihydrodicyclopentadienyl(meth)acrylat, Limonen-(meth)acrylat, Hexen(meth)acrylat, Dimethylamino-ethyl(meth)acrylat und Bisphenol-A-Diglycidetherdi(meth)acrylat. Geeignet sind ferner Acrylamide bzw. Methacrylamide wie beispielsweise Hexamethylenbis(meth)acrylamid. Geeignete Fumarate sind beispielsweise Diethylfumarat, Dibutylfumarat, Dioctylfumarat. Geeignete Maleinsäurederivate sind beispielsweise Dibutylmaleinat, Dioctylmaleinat, Laurylmaleinimid.

Geeignet sind ferner Polyester(meth)acrylate, Polyether(meth)acrylate, Polyurethan(meth)acrylate, Polybutadien-(meth)acrylate, Polyisopren-(meth)acrylate. Die Acrylate bzw. Methacrylate können weitere funktionelle Gruppen wie beispielsweise Amidgruppen, Sulfonsäureestergruppen oder Sulfonsäureamidgruppen enthalten. Geeignet sind auch teilfluorierte oder vollständig fluorierte Acrylate oder Methacylate und Siliconacrylate.

Selbstverständlich können auch Gemische mehrerer verschiedener Monomere eingesetzt werden.

Die Wahl des Monomeren hängt naturgemäß auch vom Material der polymeren Trägerschicht ab. Sollen mit dem erfindungsgemäßen Verfahren unpolare, weichelastische Flexodruckformen aufgebaut werden, dann sind besonders bevorzugte Monomere Ethylhexylacrylat, Hexandioldiacrylat, Hexandioldimethacrylat, Dodecandioldiacrylat, Dodecandioldimethacrylat, Cyclohexylacrylat, Cyclohexylmethacrylat, Isobornylacrylat, Isobornylmethacrylat sowie Dihydrodicyclopentadienylacrylat bzw. -methacrylat.

Das mindestens eine reaktive Monomer ist in der Flüssigkeit bevorzugt in einem Anteil von 50 Gew.-% bis 100 Gew.-%, besonders bevorzugt in einem Anteil von 80 Gew.-% bis 100 Gew.-% enthalten. Ganz besonders bevorzugt enthält die reaktive Flüssigkeit mehr als 90 Gew.-% Monomer.

Optional kann die Flüssigkeit noch weitere Komponenten umfassen. Die weiteren Komponenten sind bevorzugt ausgewählt aus Fotoinitiatoren, Weichmachern, Emulgatoren, Diffusionshilfsmitteln, Lösungsmitteln und oberflächenaktive Substanzen. Mit oberflächenaktiven Substanzen kann beispielsweise das Benetzungsverhalten der Flüssigkeit auf der Oberfläche der polymeren Substratschicht gesteuert werden.

Die Flüssigkeit kann optional einen Fotoinitiator umfassen. Die Menge an Fotoinitiator in der Flüssigkeit kann 0 Gew.-% bis 10 Gew.-% betragen.

Der verwendete Träger ist bevorzugt als Verbundmaterial ausgebildet und umfasst neben der polymeren Substratschicht typischerweise einen dimensionsstabilen Träger beispielsweise eine dimensionsstabile Trägerfolie wie eine Polyester-Folie oder ein Metallblech wie Aluminium oder Stahl. In einer Ausführungsform der Erfindung ist der Träger eine dimensionsstabile Zylinderhülse. Gegebenenfalls können zwischen der dimensionsstabilen Folie, dem dimensionsstabilen Metallträger oder der dimensionsstabilen Zylinderhülse und der Substratschicht weitere Zwischenschichten angeordnet sein. Eine solche Zwischenschicht kann beispielsweise eine haftvermittelnde Schicht sein.

Als Material für die dimensionsstabile Trägerfolie kommen Polyethylenterephthalat (PET), Polybutylenterephthalat (PBT), Polyethylennaphthalat (PEN) oder Polycarbonat (PC) in Frage. Geeignet sind insbesondere PET-Folien mit einer Dicke von 100 bis 200 µm.

Handelt es sich bei der Reliefdruckform um ein Flexodruckelement mit einer zylindrischen Form (Sleeve), so kommen als dimensionsstabile Zylinderhülse neben runden Polyesterhülsen auch mit Glasfasern verstärkte Polyester-Hülsen oder andere runde Trägermaterialien wie Nickelhülsen in Frage.

Das Bindemittel der polymeren Substratschicht richtet sich im Wesentlichen nach den Anforderungen des jeweiligen Druckverfahrens. Das erfindungsgemäße Verfahren ist nicht auf das Flexodruckverfahren beschränkt. Sollen beispielsweise harte Reliefdruckformen hergestellt werden, die im Buchdruckverfahren oder im Tiefdruckverfahren zum Einsatz kommen, dann wird man als Bindemittel für die Trägerschicht harte Polymere wie beispielsweise Polyvinylalkohol, teil- oder hochverseifte Polyvinylacetate oder Polyamide verwenden.

Um die für den Flexodruck typischen weichelastischen Eigenschaften der Druckform zu erreichen, werden als Bindemittel der polymeren Substratschicht bevorzugt weiche, elastomere Materialien eingesetzt.

Als weiche, elastomere Materialien kommen beispielsweise Polybutadien, Polyisopren, Copolymere aus Butadien und Styrol, Copolymere aus Isopren und Styrol, Styrol-Butadien-Blockcopolymere, Styrol-Isopren-Blockcopolymere, Styrol-Ethylen/Butylen-Blockcopolymere, Styrol/Isopren/Butadien/Styrol-Blockcopolymere, Ethylen-Propylen-Dien-Kautschuke, Silicon-Kautschuke, Naturkautschuke, Chloroprenkautschuke, Nitrilkautschuke, Polyisobutylen und weichelastische Polyurethane in Betracht.

Bevorzugt eingesetzt werden thermoplastisch verarbeitbare, elastomere Blockcopolymere. Die thermoplastisch-elastomeren Blockcopolymere umfassen mindestens einen Block, welcher im Wesentlichen aus Alkenylaromaten besteht und mindestens einen Block, welcher im Wesentlichen aus 1,3-Dienen besteht. Bei den Alkenylaromaten kann es sich beispielsweise um Styrol, α-Methylstyrol oder Vinyltoluol handeln. Bevorzugt handelt es sich um Styrol. Bei den 1,3-Dienen handelt es sich bevorzugt um Butadien und/oder Isopren. Bei diesen Blockcopolymeren kann es sich sowohl um lineare, verzweigte oder radiale Blockcopolymere handeln. Im Allgemeinen handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Handelsübliche Dreiblockcopolymere enthalten häufig gewisse Anteile an Zweiblockcopolymeren. Die Dien-Einheiten können 1,2- oder 1,4-verknüpft sein. Weiterhin einsetzbar sind auch thermoplastisch elastomere Blockcopolymere mit Endblöcken aus Styrol und einem statistischen Styrol-Butadien-Mittelblock. Selbstverständlich können auch Gemische mehrerer thermoplastisch-elastomerer Blockcopolymere eingesetzt werden.

Ferner können thermoplastisch verarbeitbare elastomere Blockcopolymere eingesetzt werden, die teilweise oder vollständig fluoriert sind oder in die fluorierte Seitenketten eingebaut sind. Diese Polymere verleihen der Substratschicht eine farbabstoßende Eigenschaft, die sich beim Druck mit niedrigem Relief - insbesondere bei Anwendungen im Elektronikbereich - vorteilhaft auswirkt.

Das thermoplastische elastomere Material der polymeren Substratschicht besteht bevorzugt überwiegend aus einem Polymer ausgewählt aus Poly(styrol-butadien-styrol) (SBS), Poly(styrol-isopren-styrol) (SIS), Ethylen-Propylen-Dien-Kautschuk (EPDM) und anderen SB-Blockcopolymeren. Gut geeignet sind auch Poly(styrol-butadien/styrol-styrol)-Blockcopolymere, die unter dem Handelsnamen Styroflex® kommerziell verfügbar sind.

Die Gesamtmenge an verwendeten Bindemittel bzw. Polymeren in der polymeren Substratschicht beträgt üblicherweise 50 bis 100 Gew.-% bezüglich der Summe aller Bestandteile der Substratschicht, bevorzugt 50 bis 90 Gew.-% und besonders bevorzugt 60 bis 85 Gew.-%.

Bevorzugt umfasst die polymere Substratschicht einen oder mehrere Fotoinitiatoren. Geeignete Fotoinitiatoren bzw. Fotoinitiatorsysteme umfassen Benzoin oder Benzoinderivate, wie Methylbenzoin oder Benzoinether, Benzilderivate, wie Benzilketale, Acylarylphosphinoxide, Acylarylphosphinsäureester, Mehrkernchinone oder Benzophenone. Die Menge an Fotoinitiator in der polymeren Substratschicht beträgt in der Regel 0,1 bis 10 Gew.-%, bevorzugt 1 bis 5 Gew.-% und besonders bevorzugt 1,5 bis 3 Gew.-%, bezogen auf die Menge (Gewicht) aller Bestandteile der Substratschicht.

Enthält das Material der polymeren Substratschicht einen Fotoinitiator, so ist es bevorzugt, wenn die das reaktive Monomer enthaltende Flüssigkeit frei von Fotoinitiatoren ist. Da das reaktive Monomer nach Aufbringen auf die Oberfläche der Substratschicht in diese eindiffundiert, und in der Substratschicht der Fotoinitiator bereits vorhanden ist, muss der Flüssigkeit kein Fotoinitiator zugesetzt werden. Durch den Verzicht auf einen Fotoinitiator in der Flüssigkeit kann diese einfacher und sicherer gehandhabt werden, da die Gefahr eines unerwünschten Aushärtens vor dem Aufbringen auf die Substratschicht reduziert wird.

Das verwendete Material für die polymere Substratschicht ist bevorzugt frei von reaktiven Monomeren oder enthält weniger als 10 Gew.-% an reaktiven Monomeren. Da die reaktiven Monomere mit der Flüssigkeit in die polymere Substratschicht eindiffundieren, muss die polymere Substratschicht keine reaktiven Monomere enthalten. Ein möglichst geringer Gehalt an reaktiven Monomeren in der polymeren Substratschicht ist zudem vorteilhaft, da dann die Eigenschaften des erzeugten Reliefs im Wesentlichen durch das Bindemittel bzw. das Material der polymeren Substratschicht bestimmt werden.

Aus drucktechnischer Sicht kann es jedoch vorteilhaft sein, dass die polymere Substratschicht eine geringe Menge an reaktivem Monomer, bevorzugt weniger als 10 Gew.-%, enthält. Nach Aufbau und Aushärtung des Reliefs werden dann nicht nur die erhabenen Reliefteile ausgehärtet sondern alle Bereiche der Reliefdruckform, so dass eine Reliefdruckform mit gleichmäßigen mechanischen Eigenschaften im Reliefgrund und in den erhabenen Reliefbereichen entsteht.

Die polymere Substratschicht kann optional einen oder mehrere Weichmacher enthalten. Beispiele für Weichmacher umfassen paraffinische, naphthenische oder aromatische Mineralöle, synthetische Oligomere oder Harze wie Oligostyrol, hochsiedende Ester, oligomere Styrol-Butadien-Copolymere, oligomere α-Methylstyrol/p-Methylstyrol-Copolymere, flüssige Oligobutadiene, flüssige Polyisoprene, insbesondere solche mit einem mittleren Molekulargewicht zwischen 500 und 5000 g/mol, oder flüssige oligomere Acrylnitril-Butadien-Copolymere oder oligomere Ethylen-Propylen-Dien-Copolymere. Bevorzugte Weichmacher umfassen Weissöl, Butadienöl und Paraffinöl.

Die Menge aller Weichmacher in der polymeren Substratschicht beträgt in der Regel 1 bis 50 Gew.-% und bevorzugt 1 bis 30 Gew.-%. Die Menge der Weichmacher richtet sich auch nach dem jeweiligen Bindemittelsystem. Bei Reliefdruckplatten auf Basis eines Styrol-Isopren-Bindemittelsystems haben sich Weichmachermengen von 1 bis 10 Gew.-% bewährt. Bei Reliefdruckplatten auf Basis eines Styrol-Butadien-Bindemittelsystems haben sich Weichmachermengen von 20 bis 40 Gew.-% bewährt.

Optional kann die polymere Substratschicht noch weitere Additive wie mineralische Füllstoffe, kompressible Zusatzstoffe, Pigmente oder Farbstoffe enthalten. Als Füllstoff gut geeignet sind beispielsweise Silikate oder Quarzmehle, die die Oberflächentopographie der Substratschicht verändern und die Farbübertragung im Druck beeinflussen können. Durch Zusatz von Mikrohohlkugeln kann die Kompressibilität der Substratschicht erhöht werden.

Die Menge an Füllstoffen liegt üblicherweise unter 50 Gew.-% bevorzugt bei kleiner 20 Gew.-% bezogen auf alle Komponenten der polymeren Substratschicht.

Ferner kann die polymere Substratschicht oberflächenaktive Substanzen wie beispielsweise Wachse, Silikonöle oder fluorierte Verbindungen enthalten. Wie oben beschrieben, kann es für Reliefdruckformen mit niedrigem Relief - wie sie im Elektronikbereich eingesetzt werden - erforderlich sein, die Oberfläche der polymeren Substratschicht farbabstoßend zu machen. Dies gelingt durch Zusatz von oberflächenaktiven Substanzen, die an die Oberfläche der polymeren Substratschicht diffundieren und dort einen hydrophoben, d.h. farbabstoßenden Schutzfilm ausbilden. Der Schutzfilm sollte aber gegenüber dem Monomer durchlässig sein, da ansonsten keine Diffusion und kein Reliefaufbau möglich ist.

Der Anteil an oberflächenaktiven Substanzen in der polymeren Substratschicht liegt üblicherweise bei weniger als 5 Gew.-%, bevorzugt bei weniger als 2 Gew.-%.

Auf der Oberfläche der polymeren Substratschicht befindet sich meist noch eine schützende Deckfolie, die vor der Anwendung, d.h. bevor die reaktive Flüssigkeit aufgebracht wird, abgezogen wird. Gut geeignet sind wiederum PET-Folien in einer Dicke von bevorzugt 50 µm bis 150 µm. Um ein leichtes Abziehen der Deckfolie sicherzustellen, kann die Deckfolie mit einer Antihaftbeschichtung versehen sein oder es kann eine silikonisierte Deckfolie verwendet werden.

Die Dicke der polymeren Substratschicht richtet sich im Wesentlichen nach der jeweiligen Anwendung bzw. nach der angestrebten Reliefhöhe. Die Dicke der polymeren Substratschicht sollte im Allgemeinen höher sein als die angestrebte Reliefhöhe. Für Anwendungen im Elektronikbereich, in denen geringe Reliefhöhen benötigt werden, können polymere Substratschichten von 0,1 mm bis zu 1,0 mm Dicke zum Einsatz kommen. Für den typischen Flexodruck werden Reliefhöhen von 0,3 mm bis 3,0 mm benötigt. Die polymeren Substratschichten sollten dann entsprechend mindestens 0,5 mm bis 3,0 mm dick sein. Für den Druck auf Wellpappe können noch dickere Substratschichten, bis zu 6 mm Dicke, zum Einsatz kommen.

Die polymere Substratschicht wird entweder durch Gießen aus Lösung oder aus der Schmelze durch Extrudieren und Kalandrieren hergestellt. Für die erfindungsgemäßen Anwendungen ist die Konstanz der Schichtdicke der polymeren Substratschicht über der Beschichtungsbreite und der Beschichtungslänge von entscheidender Bedeutung. Die maximale Abweichung der Schichtdicke sollte bei Schichtdicken von kleiner 1 mm bei plus/minus 10 µm liegen. Bei Schichtdicken von 1 mm bis zu 3 mm sollte die Schichtdickenabweichung maximal plus/minus 15 µm betragen.

Bevorzugt wird vor der Ausführung der Erfindung die Diffusionsgeschwindigkeit des jeweiligen Monomeren bzw. der jeweiligen Monomermischung in dem jeweiligen polymeren Substratmaterial experimentell ermittelt. So kann vorausgesagt werden, welche Einwirkungszeit notwendig ist, um eine gewünschte Reliefhöhe aufzubauen. Sollen mehrere Reliefschichten nacheinander aufgetragen werden, so wird vorzugsweise ferner ermittelt werden, wie sich die Diffusionsgeschwindigkeit des jeweiligen Monomeren ändert, wenn die polymere Substratschicht bereits eindiffundiertes Monomer enthält. Werden mehrere Reliefschichten nacheinander aufgetragen und dabei eine Zwischenhärtung durchgeführt, dann wird vorzugsweise die experimentelle Bestimmung der Diffusionsgeschwindigkeit an entsprechend präparierten Substratschichten, die bereits eindiffundiertes Monomer enthalten und gehärtet wurden, durchgeführt. Üblicherweise nimmt die Diffusionsgeschwindigkeit eines Monomeren ab, wenn die Diffusion durch ein bereits gehärtetes polymeres Netzwerk erfolgt.

Ein weiterer Aspekt der Erfindung ist es, eine Vorrichtung zur Herstellung von Reliefdruckformen bereitzustellen. Bevorzugt ist die Vorrichtung zur Durchführung der hierin beschriebenen Verfahren ausgebildet und/oder eingerichtet. Dementsprechend gelten im Rahmen des Verfahrens beschriebene Merkmale entsprechend für die Vorrichtung und umgekehrt die im Rahmen der Vorrichtung beschriebenen Merkmale entsprechend für das Verfahren. Die Vorrichtung umfasst Mittel zum bildmäßigen Aufbringen einer reaktiven Flüssigkeit auf die Oberfläche eines Trägers mit einer polymeren Substratschicht sowie Mittel zum Aushärten der in die Trägerschicht eindiffundierten, reaktiven Flüssigkeit. Die Vorrichtung ist zudem eingerichtet eines der hierin beschriebenen Verfahren auszuführen.

Die Mittel zum Aushärten der eindiffundierten, reaktiven Flüssigkeit sind bevorzugt als UV-Lichtquelle ausgestaltet, mit der die Oberfläche des Trägers bestrahlt werden kann. Besonders bevorzugt ist die UV-Lichtquelle in Form einer LED-Leiste ausgestaltet, die die Breite des Trägers überspannt und relativ zum Träger beweglich ist.

Bevorzugt umfasst die Vorrichtung des Weiteren Mittel zum Berechnen von Auftragsmustern, wobei ein Auftragsmuster vorgibt, an welchen Bereichen der Oberfläche die reaktive Flüssigkeit aufgetragen wird.

Die Erfindung und das erfindungsgemäße Verfahren werden in den nachstehenden Beispielen erläutert.

Kurze Beschreibung der Figuren
- Figur 1: zeigt ein durch das Eindiffundieren eines Tröpfchens gebildetes Plateau,
- Figur 2: zeigt ein gemessenes Relief aufgebaut aus zwei Reliefschichten ohne Immobilisierung,
- Figur 3: zeigt ein gemessenes Relief aufgebaut aus zwei Reliefschichten mit Immobilisierung,
- Figur 4: zeigt ein gemessenes Relief, Versuch 1, Diffusion durch 1 mm Lochschablone,
- Figur 5: zeigt ein gemessenes Relief, Versuch 1, Diffusion durch 3 mm Lochschablone und
- Figur 6: zeigt ein gemessenes Relief, Versuch 1, Diffusion durch 10 mm Lochschablone.

Die folgenden Einsatzstoffe wurden verwendet (alle %-Angaben in Gew.-%):
Quintac 3621C, radiales Styrol-Isopren-Styrol-Blockcopolymer mit 15% Styrol von Nippon Zeon.
Kraton KX405, lineares Styrol-Butadien-Styrol-Blockcopolymer mit einem Styrolanteil von 24% von Kraton.
Styroflex 2G66, ein Styrol-Butadien/Styrol-Styrol-Blockcopolyner mit einem Styrolanteil von 65% von Styrolution.
Nordel IP4725P, ein EPDM-Kautschuk mit 70% Ethylen, 25% Propylen und 5% Ethylidennorbornen von Dow.
BDK, Benzildimethylketal von BASF.
Weißöl Winog 70, paraffinisches Weißöl von Shell.
Nisso PB1000, Polybutadienöl mit >85% 1,2-vinyl-Anteil von Nippon Soda.
Hexamoll DINCH, 1,2-Cyclohexandicarbonsäurediisononylester von BASF.
Syloid ED50, amorphes Siliziumdioxid, mittlere Teilchengröße ca. 8µm von Grace.
HDDA, Hexandioldiacrylat, HDMA2, Hexandioldimethacrylat, EHA, 2-Ethylhexylacrylat, Monomere von BASF.

### Beispiele

### Experimentelle Bestimmung der Diffusionsgeschwindigkeiten ausgewählter Monomere in ausgewählten polymeren Substratmaterialien

Die in Tabelle 1 beschriebenen polymeren Substratschichten (alle Angaben in der Tabelle 1 sind in Gew.-%) wurden wie folgt hergestellt. Die jeweiligen Bindemittel wurden mit den angegebenen Weichmachern und jeweils 5 Gew.-% Photoinitiator in einem ZSK 53 Doppelschneckenextruder aufgeschmolzen, homogenisiert und durch eine Breitschlitzdüse ausgetragen und anschließend zwischen zwei PET-Folien kalandriert. Als Deckfolie wurde eine 100 µm dicke, silikonisierte Mylar PET Folie verwendet. Als Trägerfolie wurde eine 125 µm dicke Melinex D 740 Trägerfolie eingesetzt, die zuvor mit einer ca. 5 µm dünnen, isocyanatbasierten Haftlackschicht beschichtet worden war. Die Gesamtstärke des Verbundes aus Trägerfolie, polymerer Substratschicht und Deckfolie betrug 1,8 mm. Der Verbund wurde auf einem Vakuumsaugband abgezogen und nach dem Abkühlen zu einzelnen Platten zugeschnitten.

**Tabelle1**

| | S-I-S Blockcopolymer | S-B-S Blockcopolymer | EPDM-Kautschuk | S-B/S-S Blockcopolymer |
|---|---|---|---|---|
| Quintac 3621C | 85% | | | |
| Kraton KX405 | | 75% | | |
| Nordel IP 4725P | | | 75% | |
| Styroflex 2G66 | | | | 75% |
| BDK | 5% | 5% | 5% | 5% |
| Weißöl Winog 70 | 10% | | 20% | |
| Nisso PB 1000 | | 20% | | |
| Hexamoll DINCH | | | | 20% |

Zur Bestimmung der Diffusionsgeschwindigkeiten wurde jeweils ein makroskopischer Tropfen eines Monomeren mittels einer Dosierspritze (Volumen 50 µl) auf ein ausgewähltes Trägermaterial aufgebracht. Der Tropfen wurde für eine definierte Einwirkungszeit auf der polymeren Substratschicht belassen. Danach wurde überschüssiges Monomer durch Abspülen mit i-Propanol entfernt und das entstandene Relief durch Belichtung mit UVA-Licht (10 Minuten, Röhrenbelichtung, nyloflex FIII Belichter von Flint Group) fixiert. Danach wurde die Oberfläche für weitere 3 Minuten mit UVC-Licht (nyloflex F III Belichter) bestrahlt, um die Oberfläche zu entkleben, und das entstandene Relief mittels Perthometermessung ermittelt.

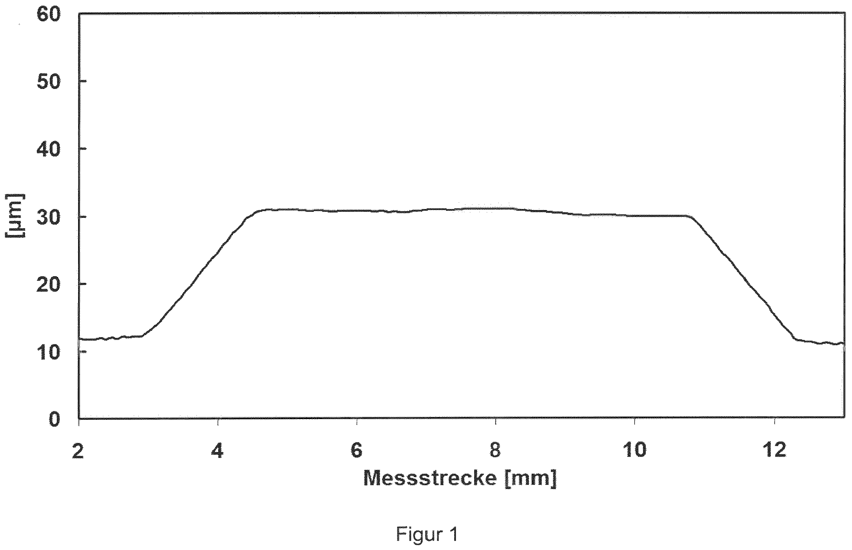

Figur 1 zeigt eine exemplarische Tropfenmessung bei einer Temperatur von 30°C, bei der als Monomer HDDA und als Trägermaterial das SIS-basierende Trägermaterial aus Tabelle 1 verwendet wurde. Die Diffusionszeit betrug 20 Minuten. Aus dem Diagramm kann eine gebildete Reliefhöhe von 20 µm ermittelt werden.

Führt man das Experiment für verschiedene Einwirkungszeiten durch, dann stellt man überraschenderweise fest, dass die Höhe des gebildeten Reliefs proportional zur Diffusionszeit ansteigt. Die Diffusion des Monomeren in die polymere Trägerschicht läuft folglich nicht gegen eine Sättigungskonzentration. Aus der Steigung der Geraden kann eine Diffusionsgeschwindigkeit in µm pro Zeiteinheit für ein gegebenes Monomer/Substratpaar ermittelt werden. Tabelle 2 zeigt die ermittelten Diffusionsgeschwindigkeiten für ausgewählte Monomere und die polymeren Substrate aus Tabelle 1 bei Raumtemperatur (22°C). Es sei darauf hingewiesen, dass die so ermittelten Diffusionsgeschwindigkeiten wissenschaftlich nicht exakt definiert sind. Vielmehr handelt es sich um eine empirisch ermittelte Diffusionsgeschwindigkeit, mit der der Aufbau eines Reliefs nach dem erfindungsgemäßen Verfahren berechnet werden kann.

**Tabelle 2**

| Polymer Trägerschicht | Monomer | Diffusionsgeschwindigkeit in µm/min |
|---|---|---|
| S-I-S | HDDA | 0,7 |
| S-I-S | HDMA | 1,3 |
| S-I-S | EHA | 4,4 |
| S-B-S | HDDA | 2,2 |
| S-B-S | HDMA | 3,2 |
| S-B-S | EHA | 3,9 |
| S-S/B-S | HDDA | 1,7 |
| S-S/B-S | HDMA | - |
| S-S/B-S | EHA | 3,9 |
| EPDM | HDDA | - |
| EPDM | HDMA | - |
| EPDM | EHA | 2,0 |

Im Rahmen der Messgenauigkeit konnten nicht für alle Monomer/Substratpaare Diffusionsgeschwindigkeiten ermittelt werden. Für die sehr unpolare Trägerschicht auf Basis EPDM-Kautschuk konnte nur für das vergleichsweise unpolare EHA eine messbare Diffusion festgestellt werden.

### Aufbau mehrerer Reliefschichten

Zur Simulation des bildmäßigen Aufbringens mehrerer Reliefschichten aufeinander wurden die folgenden Experimente durchgeführt. Auf eine Trägerschicht auf Basis S-I-S-Kautschuk (Zusammensetzung siehe Tabelle 1), in die als Füllstoff zusätzlich 2% Gew.-% amorphes Siliziumdioxid (Syloid ED 50) eingearbeitet wurde, wurde bei 30°C 20 µl einer 1:1 Mischung aus HDA2 und HDMA2 aufgetropft und der Tropfen exakt 2 Minuten auf der Trägerschicht belassen. Danach wurde die Trägerschicht in i-Propanol getaucht, um überschüssiges Monomer zu entfernen, und mittels Druckluft trocken geblasen. Auf das entstandene, kreisförmige Reliefplateau wurde anschließend mittig ein 2 µl Tropfen derselben Monomermischung aufgebracht und wiederum exakt 2 Minuten bei 30°C auf der Platte belassen. Anschließend wurde die Platte wiederum in i-Propanol getaucht und trocken geblasen. Danach wurde die Platte 10 Minuten mit UVA- und anschließend 3 Minuten mit UVC-Licht (nyloflex F III Belichter) belichtet und das entstandene Relief fixiert und die Oberfläche entklebt.

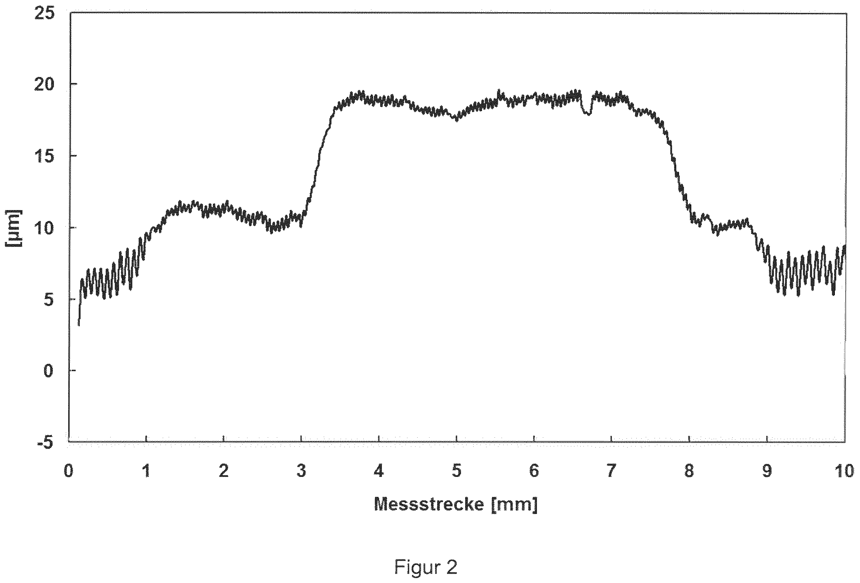

Das mittels Perthometer vermessene Profil des entstandenen Reliefs zeigt Figur 2. Es sind zwei ausgebildete Plateaus zu erkennen. Die Reliefhöhe des ersten Plateaus beträgt ca. 7 µm, die Reliefhöhe des zweiten Plateaus ist höher und beträgt ca. 10 µm. Die Diffusion der Monomermischung in das Substratmaterial, das bereits eindiffundiertes Monomer enthält, erfolgt also schneller als in ein Substratmaterial, das kein Monomer enthält.

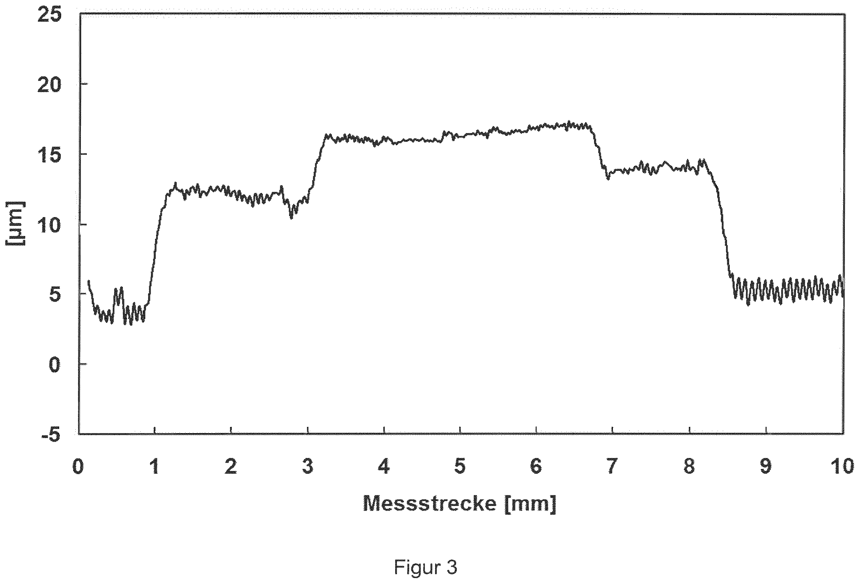

Der Versuch wurde wiederholt, mit dem Unterschied, dass vor dem Aufbringen des zweiten Tropfens eine kurze Zwischenbelichtung (30 Sekunden UVA-Belichtung, nyloflex FIII Belichter) zur Immobilisierung der eindiffundierten Monomere bzw. zur Fixierung der ersten Reliefstufe durchgeführt wurde. Das entsprechende Profil der Perthometermessung zeigt Figur 3. Die Reliefhöhe des ersten Plateaus liegt bei ca. 8 µm. Die Reliefhöhe des zweiten Plateaus ist jetzt geringer und beträgt ca. 5 µm. Die Reliefkanten sind deutlich schärfer ausgeprägt. Durch die Zwischenbelichtung werden die in der ersten Stufe eindiffundierten Monomere immobilisiert und können nicht mehr lateral diffundieren, wodurch sich eine steilere Reliefkante bildet. Die in der ersten Stufe eindiffundierten Monomere vernetzen mit dem polymeren Bindemittel der Trägerschicht und bilden ein dreidimensionales Netzwerk aus, wodurch die nachfolgende Diffusion verlangsamt wird.

Die Versuche zeigen, dass durch mehrmalige Diffusion der Monomere ein Relief schichtweise aufgebaut werden kann. Zur Vorausberechnung der Reliefhöhe müssen die Diffusionsgeschwindigkeiten des oder der Monomere in die jeweilige polymere Trägerschicht für jede aufzubringende Reliefschicht einzeln ermittelt werden.

### Maskenversuche

### Versuch 1

In ein ca. 0,5 mm dickes Aluminiumblech wurden 1mm, 3mm und 10mm Löcher gestanzt und so eine Schablone erzeugt. Diese Schablone wurde auf die SIS-basierende Trägerschicht (Tabelle 1) aufgelegt und an den Rändern mit Gewichten beschwert, um einen innigen Kontakt zwischen Maske und Oberfläche der polymeren Trägerschicht sicherzustellen.

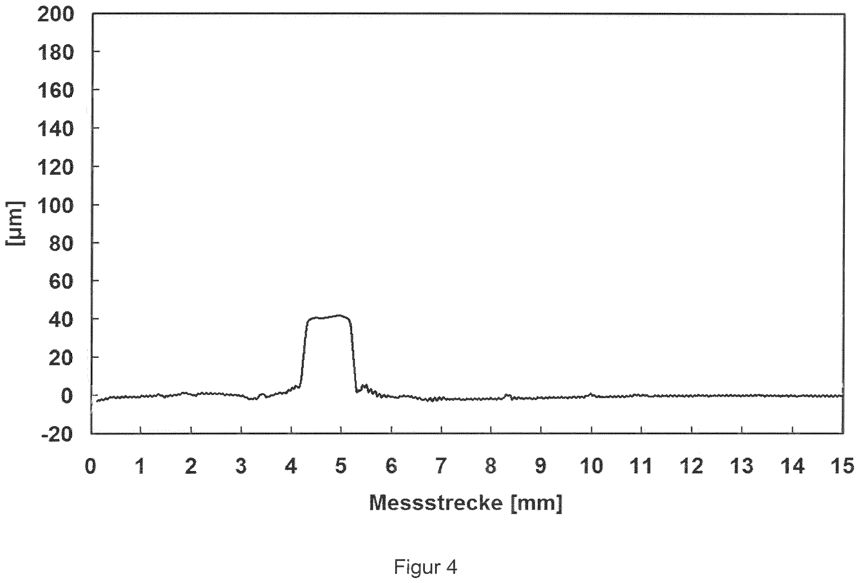

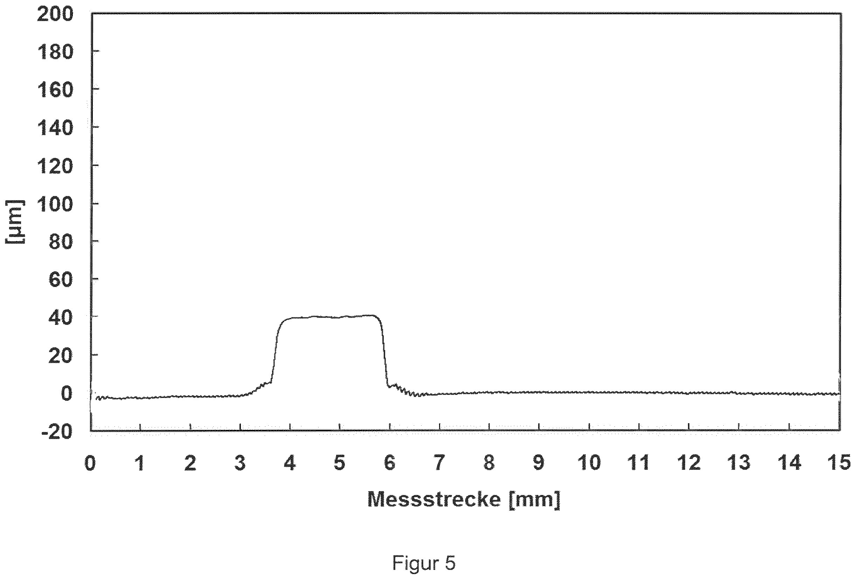

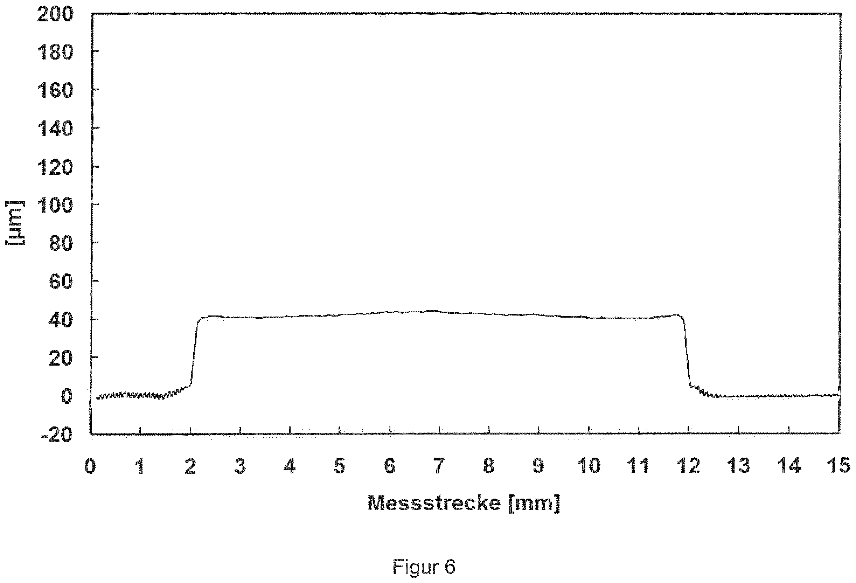

Die Löcher der Schablone wurden bei Raumtemperatur (22°C) mit HDA2 befüllt. Nach einer Diffusionszeit von 60 Minuten wurde die Schablone von der Trägerschicht entfernt. Überschüssiges Monomer wurde mit i-Propanol abgespült und die Reliefform mit Druckluft trocken geblasen. Anschließend wurde das Relief durch Belichtung mit UVA-Licht (10 Minuten, nyloflex F III Belichter) fixiert und die Oberfläche mittels UVC-Belichtung (3 Minuten, nyloflex F III Belichter) entklebt. Das entstandene Relief wurde mittels Perthometer vermessen (siehe Figuren 4, 5 und 6).

Die aufgebauten Punkte wiesen steile Flanken auf. Die Oberfläche der Punkte war eben und gleichmäßig. Die ermittelten Reliefhöhen betrugen 42 µm (10 mm Punkt), 42 µm (3 mm Punkt) und 40 µm (1 mm Punkt).

### Versuch 2

Versuch 1 wurde wiederholt, wobei die Temperatur für das Eindiffundieren des Monomeren auf 40°C eingestellt wurde.

Wiederum hatten die aufgebauten Punkte steile Flanken und eine ebene, gleichmäßige Oberfläche. Auf Grund der höheren Diffusionsgeschwindigkeit wurde ein höheres Relief ausgebildet. Die Reliefhöhen betrugen 108 µm (10 mm Punkt), 106 µm (3 mm Punkt) und 108 µm (1 mm Punkt).

Die Reliefdruckform wurde anschließend mittels eines kompressiblen Klebebands auf den Zylinder einer Flexodruckmaschine aufgeklebt und mit Alkoholfarbe gedruckt. Die Druckparameter sind in Tabelle 3 zusammengefasst.

**Tabelle 3**

| | |
|---|---|
| Druckmaschine | F&K FP 6S/8 |
| Substrat | PE-Folie |
| Druckfarbe | Siegwerk NC4012 Cyan |
| Viskosität Druckfarbe | 22 sec |
| Aniloxwalze | 460 L/cm, 3,5 g/cm³ |
| Klebeband | Lohmann 5.3 |
| Druckqeschwindigkeit | 80 m/min |
| Druckbeistellung | +30 µm über Kissprint |

Bei der gewählten Druckbeistellung druckten alle Reliefpunkte gleichmäßig aus. Die einzelnen gedruckten Punkte waren gedeckt und wiesen keinen übermäßigen Quetschrand auf. Die Durchmesser der Oberfläche der Punkte auf der Druckform sowie im Druck zu Druckbeginn und nach 500 gedruckten Exemplaren wurde mikroskopisch ermittelt. Ferner wurde die Mikro Shore A-Härte an der Oberfläche der Punkte gemessen (siehe Tabelle 4).

**Tabelle 4**

| | | | |
|---|---|---|---|
| Lochdurchmesser Schablone | 1mm | 3mm | 10mm |
| oberer Punktdurchmesser auf Druckform | 0,74 mm | 2,55 mm | 9,40 mm |
| Gedruckter Punktdurchmesser (Druckanfang) | 0,82 mm | 2,73 mm | 9,62 mm |
| Gedruckter Punktdurchmesser (Druckende) | 0,80 mm | 2,75 mm | 9,58 mm |
| Mikroshore A Härte | Nicht messbar | 68 | 67 |

Die Durchmesser der Reliefpunkte an der Oberfläche sind durchweg geringer als der jeweilige Lochdurchmesser der Schablone. Die Durchmesser der gedruckten Punkte sind dagegen 0,1 mm bis 0,2 mm größer als die Punktdurchmesser auf der Reliefdruckform. Diese Zunahme ist flexotypisch und auf das Quetschen der niedrigviskosen Flexodruckfarbe zurückzuführen. Im Rahmen der Messgenauigkeit konnte keine Quellung der Druckform durch die Druckfarbe festgestellt werden, d.h. die Größe der gedruckten Punkte veränderte sich während des Druckes nicht. An den größeren Reliefpunkten wurde die Mikroshore A-Härte ermittelt. Auch diese Werte lagen mit 67 bzw. 68 Shore A im flexotypischen Bereich. Eine nach dem Stand der Technik standardmäßig belichtete und ausgewaschene Flexodruckform (nyloflex ACE 1,7 mm von Flint Group) hat an der Oberfläche eine Mikroshore A-Härte von 64.

Der Versuch bestätigt, dass mit dem erfindungsgemäßen Diffusionsverfahren flexotypische Reliefdruckformen generativ aufgebaut werden können und, dass mit dem erfindungsgemäßen Verfahren Flexodruckformen mit der notwendigen Weichelastizität und Quellbeständigkeit erhalten werden.

## Patentansprüche

1. Verfahren zur Herstellung von Reliefdruckformen, bei dem ein Träger mit einer polymeren Substratschicht bereitgestellt wird und ein Relief an einer Oberfläche der Substratschicht schichtweise ausgebildet wird, wobei das Relief ausgebildet wird mittels
a) einfachen oder mehrfachen Aufbringens einer Flüssigkeit enthaltend mindestens ein reaktives Monomer auf die Oberfläche der Substratschicht,
b) Eindiffundieren des reaktiven Monomers in die polymere Substratschicht für eine vorgegebene Einwirkzeit und
c) Aushärten des Reliefs,
wobei in Schritt a) die Flüssigkeit bildmäßig auf die Oberfläche aufgetragen wird und wobei nach der vorgegebenen Einwirkzeit gemäß Schritt b) gegebenenfalls auf der Oberfläche verbliebene nicht eindiffundierte Flüssigkeit von der Oberfläche entfernt wird und in Schritt c) ein Aushärten des Reliefs umfassend das Polymer der Substratschicht und eindiffundiertes reaktives Monomer erfolgt.

2. Verfahren nach Anspruch 1, **dadurch gekennzeichnet, dass** die Schritte a) bis c) nur einmalig durchlaufen werden, wobei in Schritt a) nur ein einfaches Aufbringen der Flüssigkeit erfolgt.

3. Verfahren nach Anspruch 1, **dadurch gekennzeichnet, dass** die Schritte a) und b) 2 bis 100 mal durchlaufen werden und ein Aushärten gemäß Schritt c) nach dem letzten Durchlaufen des Schritts b) erfolgt.

4. Verfahren nach Anspruch 3, **dadurch gekennzeichnet, dass** der Schritt c) zusätzlich nach jedem n-ten Durchlauf der Schritte a) und b) im Anschluss an den Schritt b) ausgeführt wird, wobei n von 2 bis 10 gewählt ist.

5. Verfahren nach einem der Ansprüche 1 bis 4, **dadurch gekennzeichnet, dass** das Aufbringen der Flüssigkeit durch Aufbringen einer Maske auf die Oberfläche und Auftragen der Flüssigkeit durch die Maske hindurch erfolgt, wobei die Flüssigkeit auf die nicht-maskierten Teile der Oberfläche gelangt und wobei die Maske derart ausgestaltet ist, dass ein vorgegebenes Abbild erzeugt wird.

6. Verfahren nach einem der Ansprüche 1 bis 5, **dadurch gekennzeichnet, dass** die Flüssigkeit mindestens 50 Gew.-% reaktives Monomer enthält.

7. Verfahren nach einem der Ansprüche 1 bis 6, **dadurch gekennzeichnet, dass** die Flüssigkeit weitere Komponenten ausgewählt aus Fotoinitiatoren, Weichmachern, Emulgatoren, Diffusionshilfsmittel, Lösungsmittel und oberflächenaktive Substanzen umfasst.

8. Verfahren nach einem der Ansprüche 1 bis 7, wobei das reaktive Monomer ausgewählt ist aus einem Ester oder einem Amid der Acrylsäure oder Methacrylsäure mit mono- oder polyfunktionellen Alkoholen, Aminen, Aminoalkoholen oder Hydroxyethern und -estern, einem Ester der Fumar- oder Maleinsäure oder einer Allylverbindung.

9. Verfahren nach einem der Ansprüche 1 bis 8, **dadurch gekennzeichnet, dass** das reaktive Monomer der Flüssigkeit und die polymere Substratschicht derart ausgewählt sind, dass die Diffusionsgeschwindigkeit des reaktiven Monomers in der polymeren Substratschicht im Bereich von 0,5 µm/min bis 100 µm/min liegt.

10. Verfahren nach einem der Ansprüche 1 bis 9, **dadurch gekennzeichnet, dass** das Polymer der polymeren Substratschicht ausgewählt ist aus Styrol-Butadien-Styrol (SBS)-, Styrol-Isopren-Styrol (SIS)-, Styrol-Butadien/Styrol-Styrol-, Styrol-Isopren-Butadien-Styrol (SIBS)-, Styrol-Butadien (SB)-Blockcopolymeren und Ethylen-Propylen-Dien-Kautschuk (EPDM).

11. Verfahren nach einem der Ansprüche 1 bis 9, **dadurch gekennzeichnet, dass** das Polymer der polymeren Substratschicht ausgewählt ist aus Polyvinylalkohol, teil- oder hochverseiften Polyvinylacetaten und Polyamid.

12. Verfahren nach einem der Ansprüche 1 bis 11, **dadurch gekennzeichnet, dass** die Substratschicht frei von reaktivem Monomer ist oder weniger als 10 Gew.-% reaktives Monomer enthält.

13. Verfahren nach einem der Ansprüche 1 bis 12, **dadurch gekennzeichnet, dass** die Substratschicht einen Weichmacher, ausgewählt aus Weissöl, Butadienöl, flüssigem Polyisopren, hochsiedenden Estern und Paraffinöl umfasst.

14. Verfahren nach einem der Ansprüche 1 bis 13, **dadurch gekennzeichnet, dass** die Substratschicht einen oder mehrere Fotoinitiatoren enthält.

15. Verfahren nach Anspruch 14, **dadurch gekennzeichnet, dass** die Flüssigkeit frei von Fotoinitiatoren ist.

16. Verfahren nach einem der Ansprüche 1 bis 15, **dadurch gekennzeichnet, dass** der Träger als Verbundmaterial ausgebildet ist, umfassend zumindest eine dimensionsstabile Trägerfolie und die Substratschicht.

17. Verfahren nach einem der Ansprüche 1 bis 16, **dadurch gekennzeichnet, dass** das Aushärten gemäß Schritt c) durch Einwirkung von UV-Strahlung erfolgt.

18. Verfahren nach einem der Ansprüche 1 bis 17, **dadurch gekennzeichnet, dass** der Träger in Form einer Zylinderhülse bereitgestellt wird.

## Claims

1. A process for the production of relief printing plates, where a carrier with a polymeric substrate layer is provided and a relief is formed layer-by-layer on a surface of the substrate layer, where the relief is formed by means of
a) single or multiple application of a liquid comprising at least one reactive monomer to the surface of the substrate layer,
b) diffusion of the reactive monomer into the polymeric substrate layer for a prescribed exposure time and
c) hardening of the relief,
where in step a) the liquid is applied in accordance with an image to the surface and where, after the prescribed exposure time of step b), any liquid that remains on the surface, having not diffused into the material, is removed from the surface, and in step c) the relief comprising the polymer of the substrate layer and the diffused reactive monomer is hardened.

2. The process as claimed in claim 1, **characterized in that** the steps a) to c) are implemented only once with, in step a), only single application of the liquid.

3. The process as claimed in claim 1, **characterized in that** the steps a) and b) are implemented from 2 to 100 times and hardening in step c) takes place after the final implementation of the step b).

4. The process as claimed in claim 3, **characterized in that** the step c) is also executed after every nth implementation of the steps a) and b), following the step b), where n is from 2 to 10.

5. The process as claimed in any of claims 1 to 4, **characterized in that** the liquid is applied via application of a mask to the surface and application of the liquid through the mask, where the liquid reaches the unmasked portions of the surface, and where the design of the mask is such that a prescribed replicated image is produced.

6. The process as claimed in any of claims 1 to 5, **characterized in that** the liquid comprises at least 50% by weight of reactive monomer.

7. The process as claimed in any of claims 1 to 6, **characterized in that** the liquid comprises further components selected from photoinitiators, plasticizers, emulsifiers, diffusion aids, solvents and surface-active substances.

8. The process as claimed in any of claims 1 to 7, where the reactive monomer is an ester or an amide of acrylic acid or methacrylic acid with mono- or polyfunctional alcohols, amines, aminoalcohols or hydroxyethers or -esters, an ester of fumaric or maleic acid, or an allyl compound.

9. The process as claimed in any of claims 1 to 8, **characterized in that** selection of the reactive monomer of the liquid and selection of the polymeric substrate layer are such that the diffusion velocity of the reactive monomer in the polymeric substrate layer is in the range from 0.5 µm/min to 100 µm/min.

10. The process as claimed in any of claims 1 to 9, **characterized in that** the polymer of the polymeric substrate layer is selected from styrene-butadiene-styrene (SBS), styreneisoprene-styrene (SIS), styrene-butadiene/styrene-styrene, styrene-isoprene-butadiene-styrene (SIBS) and styrene-butadiene (SB) block copolymers and ethylene-propylene-diene rubber (EPDM).

11. The process as claimed in any of claims 1 to 9, **characterized in that** the polymer of the polymeric substrate layer is selected from polyvinyl alcohol, partially or highly hydrolyzed polyvinyl acetates and polyamide.

12. The process as claimed in any of claims 1 to 11, **characterized in that** the substrate layer is free from reactive monomer or comprises less than 10% by weight of reactive monomer.

13. The process as claimed in any of claims 1 to 12, **characterized in that** the substrate layer comprises a plasticizer selected from white oil, butadiene oil, liquid polyisoprene, high-boiling-point esters and paraffin oil.

14. The process as claimed in any of claims 1 to 13, **characterized in that** the substrate layer comprises one or more photoinitiators.

15. The process as claimed in claim 14, **characterized in that** the liquid is free from photoinitiators.

16. The process as claimed in any of claims 1 to 15, **characterized in that** the carrier is composite material comprising at least one dimensionally stable carrier sheet and the substrate layer.

17. The process as claimed in any of claims 1 to 16, **characterized in that** the hardening in step c) takes place via exposure to UV radiation.

18. The process as claimed in any of claims 1 to 17, **characterized in that** the carrier provided takes the form of a cylinder sleeve.

## Revendications

1. Procédé de fabrication de plaques d'impression en relief, selon lequel un support comprenant une couche de substrat polymère est préparé et un relief est formé en couches sur une surface de la couche de substrat, le relief étant formé par
a) l'application à une ou plusieurs reprises d'un liquide contenant au moins un monomère réactif sur la surface de la couche de substrat,
b) la diffusion du monomère réactif dans la couche de substrat polymère pendant un temps d'action prédéterminé et
c) le durcissement du relief,
à l'étape a), le liquide étant appliqué sur la surface suivant une image et, après le temps d'action prédéterminé selon l'étape b), le liquide non diffusé restant éventuellement sur la surface étant éliminé de la surface et, à l'étape c), un durcissement du relief comprenant le polymère de la couche de substrat et le monomère réactif diffusé ayant lieu.

2. Procédé selon la revendication 1, **caractérisé en ce que** les étapes a) à c) ne sont réalisées qu'à une reprise, seule une application à une reprise du liquide ayant lieu à l'étape a).

3. Procédé selon la revendication 1, **caractérisé en ce que** les étapes a) et b) sont réalisées 2 à 100 fois, et un durcissement selon l'étape c) a lieu après la dernière réalisation de l'étape b).

4. Procédé selon la revendication 3, **caractérisé en ce que** l'étape c) est en outre réalisée après chaque n^{e} réalisation des étapes a) et b) à la suite de l'étape b), n étant choisi de 2 à 10.

5. Procédé selon l'une quelconque des revendications 1 à 4, **caractérisé en ce que** l'application du liquide a lieu par application d'un masque sur la surface et application du liquide au travers du masque, le liquide atteignant les parties non masquées de la surface et le masque étant configuré de telle sorte qu'une image prédéterminée soit générée.

6. Procédé selon l'une quelconque des revendications 1 à 5, **caractérisé en ce que** le liquide contient au moins 50 % en poids de monomère réactif.

7. Procédé selon l'une quelconque des revendications 1 à 6, **caractérisé en ce que** le liquide comprend d'autres composants choisis parmi les photoinitiateurs, les plastifiants, les émulsifiants, les adjuvants de diffusion, les solvants et les substances tensioactives.

8. Procédé selon l'une quelconque des revendications 1 à 7, dans lequel le monomère réactif est choisi parmi un ester ou un amide de l'acide acrylique ou de l'acide méthacrylique avec des alcools, amines, amino-alcools ou hydroxyéthers et -esters mono- ou polyfonctionnels, un ester de l'acide fumarique ou maléique ou un composé d'allyle.

9. Procédé selon l'une quelconque des revendications 1 à 8, **caractérisé en ce que** le monomère réactif du liquide et la couche de substrat polymère sont choisis de telle sorte que la vitesse de diffusion du monomère réactif dans la couche de substrat polymère se situe dans la plage allant de 0,5 µm/min à 100 µm/min.

10. Procédé selon l'une quelconque des revendications 1 à 9, **caractérisé en ce que** le polymère de la couche de substrat polymère est choisi parmi les copolymères séquencés de styrène-butadiène-styrène (SBS), de styrène-isoprène-styrène (SIS), de styrène-butadiène/styrène-styrène, de styrène-isoprène-butadiène-styrène (SIBS), de styrène-butadiène (SB), et le caoutchouc d'éthylène-propylène-diène (EPDM).

11. Procédé selon l'une quelconque des revendications 1 à 9, **caractérisé en ce que** le polymère de la couche de substrat polymère est choisi parmi l'alcool polyvinylique, les polyacétates de vinyle partiellement ou hautement saponifiés et le polyamide.

12. Procédé selon l'une quelconque des revendications 1 à 11, **caractérisé en ce que** la couche de substrat est exempte de monomère réactif ou contient moins de 10 % en poids de monomère réactif.

13. Procédé selon l'une quelconque des revendications 1 à 12, **caractérisé en ce que** la couche de substrat comprend un plastifiant, choisi parmi l'huile blanche, l'huile de butadiène, le polyisoprène liquide, les esters de point d'ébullition élevé et l'huile de paraffine.

14. Procédé selon l'une quelconque des revendications 1 à 13, **caractérisé en ce que** la couche de substrat contient un ou plusieurs photoinitiateurs.

15. Procédé selon la revendication 14, **caractérisé en ce que** le liquide est exempt de photoinitiateurs.

16. Procédé selon l'une quelconque des revendications 1 à 15, **caractérisé en ce que** le support est configuré sous la forme d'un matériau composite, comprenant au moins une feuille support de dimensions stables et la couche de substrat.

17. Procédé selon l'une quelconque des revendications 1 à 16, **caractérisé en ce que** le durcissement selon l'étape c) a lieu sous l'effet d'un rayonnement UV.

18. Procédé selon l'une quelconque des revendications 1 à 17, **caractérisé en ce que** le support est préparé sous la forme d'une gaine cylindrique.
